# EUROPEAN PATENT SPECIFICATION

(11) **EP 4 177 786 B1**
(45) Date of publication and mention of the grant of the patent: **08.01.2025**
(21) Application number: 21306564.2
(22) Date of filing: 08.11.2021
(51) Int. Cl.: G06G 7/184

(54) **ELECTRONIC INTEGRATOR CIRCUIT FOR DRIVING INDUCTOR**
ELEKTRONISCHE INTEGRATORSCHALTUNG ZUR ANSTEUERUNG EINES INDUKTORS
CIRCUIT INTÉGRATEUR ÉLECTRONIQUE DE COMMANDE D'INDUCTEUR

(43) Date of publication of application: 10.05.2023
(73) Proprietor: NXP USA, Inc., Austin TX 78735 (US)
(72) Inventor: SICARD, Thierry Michel Alain, 5656 AE Eindhoven (NL)
(74) Representative: Hardingham, Christopher Mark

(56) References cited:
- EP-A1- 0 337 857
- GROENEWOLD G ET AL: "SYSTEMATIC DISTORTION ANALYSIS FOR MOSFET INTEGRATORS WITH USE OF ANEW MOSFET MODEL", IEEE TRANSACTIONS ON CIRCUITS AND SYSTEMS II: ANALOG AND DIGITAL SIGNAL PROCESSING, INSTITUTE OF ELECTRICAL AND ELECTRONICS ENGINEERS INC, 345 EAST 47 STREET , NEW YORK N Y 10017 , USA, vol. 41, no. 9, 1 September 1994 (1994-09-01), pages 569 - 580, XP000468158, ISSN: 1057-7130, DOI: 10.1109/82.326583

## Description

### FIELD

The present disclosure relates generally to electronic integration circuits, and more specifically, to an integrator that drives an inductive coil or the like.

### BACKGROUND

Electronic integration circuits are well-known and readily available for a number of electronic applications. A conventional integrator circuit includes an operational amplifier that provides a desired current response, wave shape, or other signal conditioning functions.

The presence of an amplifier in an integrator circuit may operate under strict time and peak current conditions, which prohibits the circuit from achieving a combination of ideal characteristics in order to integrate a linear current ramp necessary for driving the integrator input.

It is desirable that a simple integrator circuit, for example, comprising few transistors including a follower stage, that is capable of driving a high peak current rise, e.g., 130mA, in a coil in 6ns or less.

Groenewold G, et al, "Systematic distortion analysis for MOSFET integrators with use of a new MOSFET model", IEEE transactions on circuits and systems II: analog and digital signal processing, Institute of Electrical and Electronics engineering Inc 41(9) 1 September 1994, pp 569-580, discloses MOSFET based on continuous time integrators, including a simple unbalanced passive-saturation integrator in which a current source in the source of the transistor is used when the input signal source cannot handle the input bias current.

European patent application, publication number EP 033 7857, discloses a circuit to control an inductive load by an N channel MOS power transistor. An N and P-type transistor are included to respectively handled the negative voltage is induced by the inductor and to isolate the gate of the power transistor.

### BRIEF DESCRIPTION OF THE DRAWINGS

The present invention is illustrated by way of example in the accompanying figures, in which like references indicate similar elements. Elements in the figures are illustrated for simplicity and clarity and have not necessarily been drawn to scale.
FIG. 1 is a block diagram of an integrator circuit, in accordance with some embodiments
FIG. 2 is a schematic representation of an integrator circuit, in accordance with an embodiment.
FIG. 3 is a schematic representation of an integrator circuit, in accordance with another embodiment.
FIG. 4A and 4B are graphs of a voltage and current, respectively, produced by the integrator circuit of FIG. 3.
FIG. 5 is a graph illustrating various pulses produced in the integrator circuit of FIG. 3.
FIG. 6 is a graph of the coil currents corresponding to the pulses illustrated in FIG. 5.
FIG. 7 is a schematic representation of an integrator circuit, in accordance with another embodiment.
FIG. 8 is a graph illustrating various currents formed in the integrator circuit of FIG. 7.
FIG. 9 is a schematic representation of an integrator circuit generating a current source, in accordance with another embodiment.
FIG. 10 is a graph illustrating various voltages and currents formed in the integrator circuit of FIG. 9.

### DETAILED DESCRIPTION

In brief overview, embodiments of the present inventive concept include a simple integrator circuit that can drive a small inductor with an integrator amplifier that generates a quadratic shape pulse based on the integration of a linear ramp current. The integrator circuit operates under strict and tight parameters, in particular, providing a bias current to maintain the integrator input at the same voltage with little or no input current with respect to a small inductor, where the signals having a predetermined longer pulse duration (e.g., 6ns compared to conventional 2ns or 4ns pulse durations) and high peak current (e.g., 150mA). The integrator can be implemented in various electronic applications including, but by no means limited to, automotive, industrial, and consumer applications. One example application may include a 10Mbit/s isolated communication bus for a battery management system (BMS), which requires the integrator to drive a 30nH inductive load requiring a pulse producing a 130mA current in 6ns. Other high speed isolated communication network electronic circuits may equally apply, for example, a microcontroller, battery cell controller, transceiver, and so on.

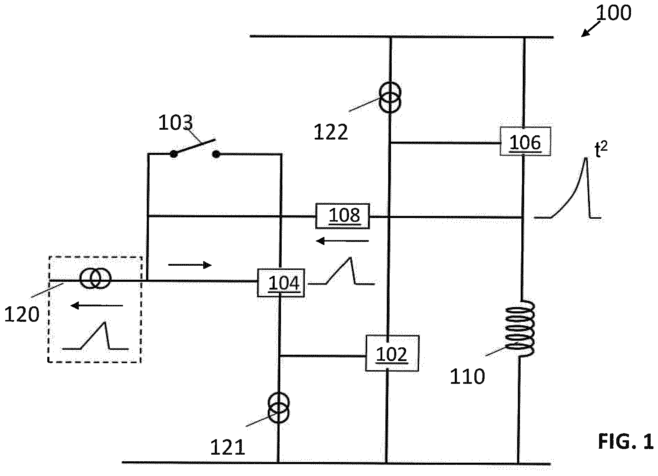

FIG. 1 is a block diagram of an integrator circuit 100 of a communication bus 10, in accordance with some embodiments. The integrator circuit 100 can be implemented in various electronic applications including, but by no means limited to, automotive, industrial, and consumer applications including signal processing or battery management systems. One application includes the implementation of a computer chip or related electronic integration circuit for a communication bus.

As shown in FIG. 1, the integrator circuit 100 can comprise a first stage driver 102, an integrator input element 104, an inductive load driver 106, and an integrator capacitor 108. The first stage driver 102, the integrator input element 104, and the inductive load driver 106 are formed of Metal-Oxide-Semiconductor Field-Effect Transistors (MOSFETs), and preferably NMOS transistors.

The inductive load driver 106 is constructed and arranged to drive an inductive load such as a coil 110 as a voltage follower stage. The inductive load driver 106 can have a source coupled to both the integrator capacitor 108 and the coil 110. The capacitor 108 is coupled to the conductive path between the inductive load driver 106 and the coil 110. The inductive load driver 106 further has a drain and gate each coupled to a current source 122, for example, a 2mA current source.

The first stage driver 102 is constructed and arranged to drive the follower stage via the drain of the first stage driver 102, which can be in electrical communication with the gate of the inductive load driver 106. In some embodiments, the first stage driver 102 can be formed of a source follower circuit, wherein the source of the first stage driver 102 can be coupled to ground. The gate of the first stage driver 102 can be coupled between a first current source 121 and a source of the integrator input element 104. In a DC state, the gate of the integrator input element 104 can be connected to a voltage supply. In some embodiments, the voltage supply can be a 1.5V voltage supply, for example, provided by a switching device 103. The voltage may range from 1-2V, but not be limited thereto. The input current source 120 coupled to the gate of the integrator input element 104 can generate a linear current ramp from 0 to 700µA in 6ns. The first stage driver 102 can be biased, for example, at 2mA but not limited thereto, by a closed loop which controls the drain current of the integrator input 104.

During operation, the first stage driver 102, integrator input element 104, inductive load driver 106, and integrator capacitor 108 operate to provide a quadratic output voltage to drive a current in the 30nH coil 110 by integrating a linear current ramp in the capacitor 108. Accordingly, the integrator circuit 100 requires only three MOS transistors, including the follower stage, to provide a quadratic output voltage of 2.5V in 6ns and drive 120mA in the 30nH coil by integrating a linear current in the capacitor 108, and produce negligible or no input current (e.g., integrator input element 104) resulting in an integration of the linear input current in the integrator capacitor 108.

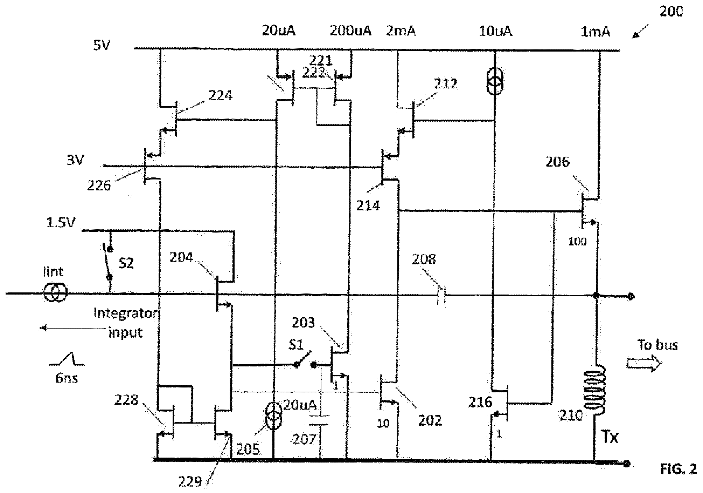

FIG. 2 is a schematic representation of an integrator circuit 200, in accordance with an embodiment. As shown, the integrator circuit 200 can be part of an isolated communication bus or the like, for example, a capacitive isolation line at a transmit side of a transformer of a bus. The integrator circuit 200 can comprise a first stage driver 202, an integrator input element 204, an inductive load driver 206, and an integrator capacitor 208, which may be the same or similar to those described with reference to FIG. 1 but may be configured and arranged in the circuit 200 in a different manner than the circuit 100 of FIG 1. During operation, the first stage driver 202, integrator input element 204, inductive load driver 206, and integrator capacitor 208 can operate to generate an integrator current of 0A in a DC state. To achieve a 1mA bias, the circuit 200 can provide an integration of the linear input current at the capacitor 108.

In particular, the inductive load driver 206 operates as a power MOS transistor, which can be biased at 1mA in the DC state. To achieve the 1mA bias, the circuit 200 can include a copy MOS transistor 216 having a source coupled to the coil 210 and the capacitor 208, a drain coupled to a current source, for example, a 1mA source, and a gate coupled to the gate of the inductive load driver 206, which in turn has a sufficient current to drive a 30nH coil 210. The circuit 200 provides a copy of the inductive load driver current to the copy MOS transistor 216 at which the copy MOS current can be up to 100 times smaller than the inductive load driver current, assuming that the 30mH coil 210 can be a short in the DC state. For example, as shown in FIG. 2, the copy MOS transistor 216 can be set at 10µA, or in a range between 5-20µA so that the inductive load driver current can be 1 mA, or in a range between 0.5-2mA. NMOS transistor 212, and PMOS transistor 214 can be in series with the first stage driver 202 and drive the gate of the power MOS 206. The first NMOS transistor 212 may be set to have a current, e.g., 2mA, at its drain and driven by the first stage driver 202. The first stage driver 202 current (e.g., 2mA) can be controlled by a copy of the first stage circuit 202, in particular, a copy NMOS transistor 203, or 10 times smaller. In particular, the drain current of the copy NMOS transistor 203 can be forced at 200µA, or in a range between at 100-300µA with a 20µA or range between 10-30µA current pulldown current source 205 and PMOS mirror transistors 221, 222. The drain of the second PMOS mirror transistor 222 can drive the current in the integrator input element 204 through a closed loop transistor 224, wherein a control transistor 226 controls the current at the drain of the closed loop transistor 224 and the mirror transistors 228, 229. Therefore, in the DC state, the integrator current (Iint) can be 0A, or a negligible value between 0-1A, the gate of the integrator input element 204 can be connected to the voltage supply, e.g., 1.5V or a voltage range between 1-5V, and the closed loop controls the current in the integrator input element 204, which in turn can control the first stage driver 202 and the power MOS 206, and permits the power MOS 206 to drive the 30mH coil 110 as a follower stage, for example, driving a 150mA current at the coil 110 in 6ns or less.

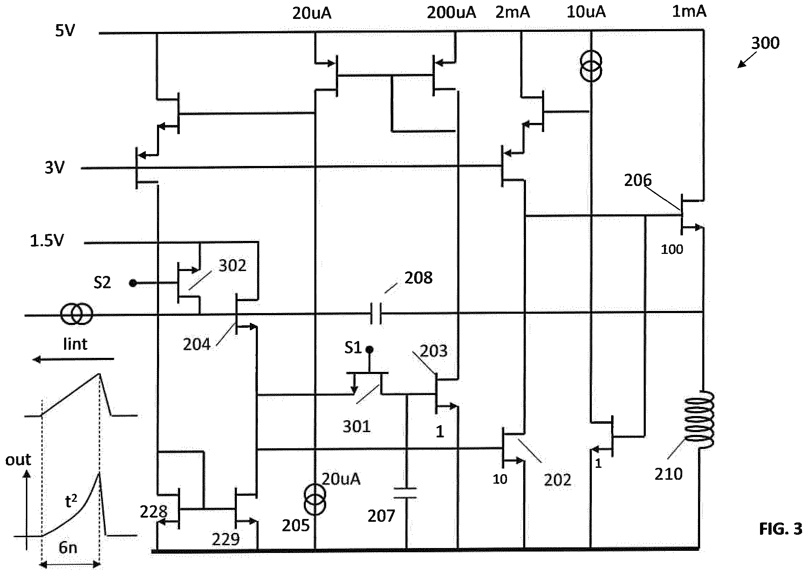

FIG. 3 is a schematic representation of an electronic integration "integrator" circuit 300, in accordance with another embodiment. The integrator circuit 300 can include components constructed and arranged in a similar manner as those of the integrator circuit 200 of FIG. 2, details of which are not repeated for brevity. In addition, the integrator circuit 300 can include a first switch 301, e.g., an NMOS transistor and a second switch 302, e.g., an NMOS transistor 302. The first switch 301 can be coupled between the copy NMOS transistor 203 and the source of the integrator input element 204. The second switch 302 can be coupled between the gate of the integrator input element 204, the voltage source (e.g., 1.5V) and the current source (Iint).

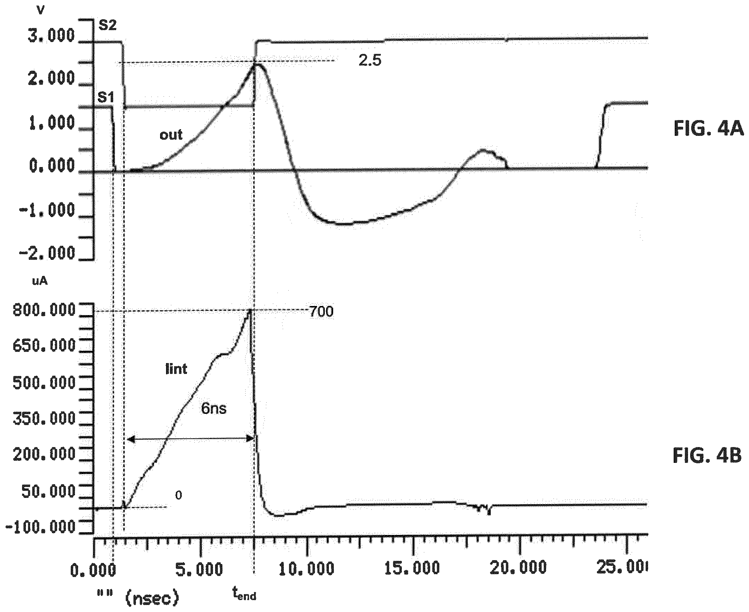

During an operation involving voltage driven pulse commands (see FIGs. 3-6), at the pulse starting point (see FIG. 4), the integrator input element 204 can be attached at a predetermined voltage such as 2.5 V, or 1-3V, with a current range of .5- 2mA, preferably 1mA in the inductive load driver 206, which functions as a final power stage NMOS transistor. When the power command can be initiated, the switch signals S1, S2 may be applied to the first switch 301 and second switch 302, respectively, to cause the first and second switches to 301, 302 to be in an open state, or inactivated, whereby the first power switch 301 can be turned off by the signal S1 transitioning from 1.5V to 0V to preserve the DC state of the copy NMOS transistor 203 for the pulse duration. The capacitor 208 connected between the gate of the copy NMOS transistor 203 and the drain of the first switch transistor 301 can allow the DC state current to be maintained at the integrator input element 204.

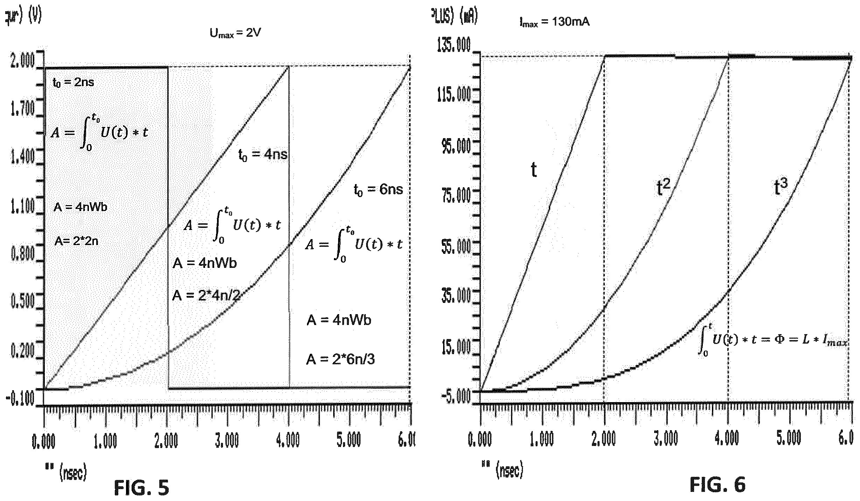

The second switch transistor 302 can be turned off when the signal S2 transitions from a higher voltage, e.g., 3V to a lower voltage, e.g., 1.5V. The input switch command (S) begins with the integration current (Iint). As the totality of the current Iint, e.g., up to 700µA, flows in the integrator capacitor 208, e.g., a 1pF capacitor, the output can have a t² shape from 0-2.5V in 6ns, as shown in FIGs. 5 and 6. According, the S2 signal can drive the t² shape.

At time t_{end} (see FIGs. 4A, 4B), when the signal S2 increases, the current in the coil 210 reaches a value of around 130 to 150mA with a t³ shape. The integration stops when the S2 signal increases and the linear Iint current can be reduced to 0A. The signal S2 increases, or changes state, when the coil current can be reduced to 0A, or a negligible current for example, 0-1mA in the DC state. At the end of the coil command, i.e., the rightmost shape shown in FIGs. 5 and 6, the current may return to 0A, or negligible current for example, 0- 1mA at the final power stage 206 in a DC state.

FIG. 5 and 6 illustrate various voltages and currents across the coil 210. As shown in FIGs. 5-6, the quadratic pulse can be selected over a square pulse and a linear pulse as the preferred command option because it allows the longer pulse of 6ns to provide the same coil current. The t² shape voltage source across the inductor allows for a longer command to achieve the same maximum current in the coil. As U=ldI/dt, the current may have a t³ shape due to the current derivation in t³ providing a voltage shown in the t² shape.

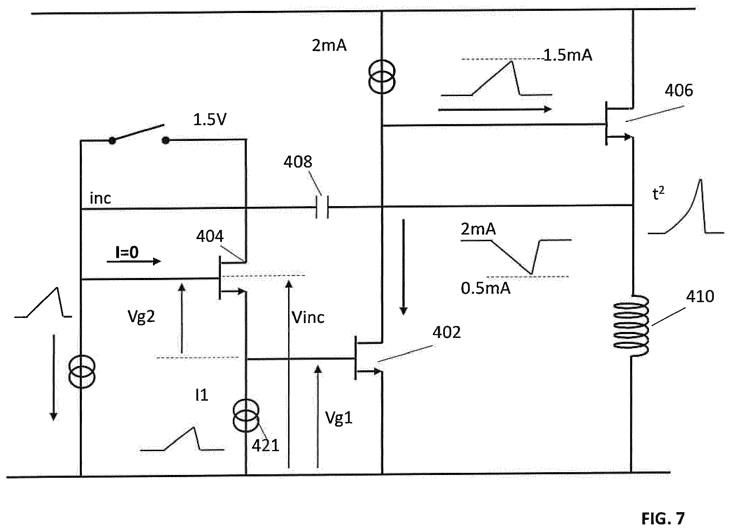

During an operation involving current integration (see FIGs. 7-8), a perfect integration circuit requires no input current at the integrator input so that the current will flow to an integrator capacitor 408. Also, a perfect integration circuit requires the frequency or the periodic time of the input wave to be less than the circuit time constant. %To comply with a desired threshold of 6ns, the integrator operates with few components, i.e., NMOS transistors 402, 404 and no operational amplifier. Components 402, 404, 406, 408, and 410 may be the same as or similar to those components described in the circuits of FIGs 1-3 so details thereof are not repeated for brevity.

During the linear current ramp integration including the generation of a t² shape voltage across the coil 410, the maximum current at the gate of the inductive load driver transistor 406 ranges from 1-2mA, preferably 1.5mA, which activates the inductive load driver 406. Here, the bias current of the first stage driver transistor 402 may be greater than 1.5mA, for example, configured to operate at 2mA. The gate current of the inductive load driver 406 may be linear. Accordingly, the drain current of the first stage driver transistor 402 can drop from 2mA to 0.5mA.

In doing so, the gate-source voltage (Vgs) of the first stage driver transistor 402 (Vg1) decreases. To achieve an integration, the gate current of the integrator input element 404, e.g., including an NMOS transistor or the like, may be 0A or a negligible current between 0-1mA. In other words, to achieve a 0uA input current, Vinc = Vg1 + Vg2 of the integrator may be constant during the time integration, for example, Vinc=Vg1+Vg2, where Vg2 is the gate-source voltage of the NMOS transistor 404. However, a significant amount of the bias current of the first stage driver transistor 402 can be applied to the gate of the follower 406. Therefore, the current at the first stage driver transistor 402 may not be constant, resulting in a drop of gate-source voltage (Vg1) of the first stage driver transistor 402.

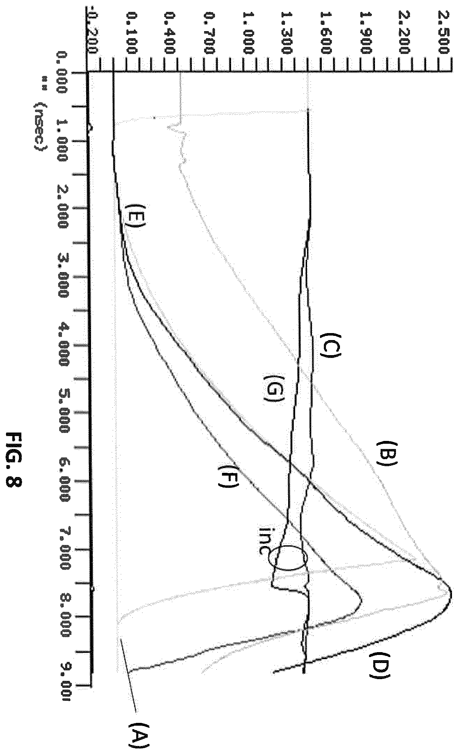

The addition of a linear current ramp at the source of the NMOS transistor 404 allows the DC bias current to contribute to the maintaining of the integrator input voltage, where little or no current is injected into the integrator input and all the linear input current instead flows into the capacitor 408 to be integrated and achieve the t² voltage shape at the opposite side of the capacitor 408. In doing so, gate-source voltage of the NMOS transistor 404 (Vg2) increases to compensate for a commensurate decrease in the gate-source voltage of the first stage driver transistor 402 (Vg1). However, since NMOS transistor 404 can be substantially less than that of the first stage driver transistor 402, the gate current of the NMOS transistor 404, for example, 1nA-100nA. As shown in FIG. 8, the gate current of the NMOS transistor 404 (A) has an average of about 5nA.

FIGs. 7 and 8 also illustrate a circuit 400 and its impact of the linear ramp current (B) of the NMOS transistor 404 of 140µA in 6ns. Also shown is a plot of the integrator input with (C) and without (D) the linear current of the NMOS transistor 404. To maintain a constant voltage (Vinc), the bias current of the integrator input element 404 may increase. As shown in FIG. 8, the voltage shown at region ( inc) can be provided with a constant current 404 (G) and with the current 404 having a current ramp to allow the voltage (Vinc) to be constant. If the gate current at integrator input element 404 is 0, the voltage (Vinc) can be flat (V). Otherwise the voltage decreases, which affects the output voltage. For example, when the drain current of NMOS transistor 402 changes, the voltage (Vg1) decreases. In DC state the current source 421 can be adjusted to arrive at Vg1+Vg2 = 1.5V. But when voltage Vg2 goes low, the current 421 may increase to increase voltage Vg2 and maintain Vg1+Vg2 = 1.5V.

Also shown is the impact on the output voltage. With the linear current of the NMOS transistor 404 at the current source 421, the output voltage may be close to the ideal t2 shape, e.g., reference curve (E). In contrast, curve (F) pertains to an output without the linear current ramp. Here, about 0.7V of the peak amplitude can be lost because a significant amount of the integration current can be applied to the integrator input. With the additional linear current at the NMOS transistor 404, which keeps the integrator input constant, a fast integrator of 6ns pulse can be obtained with the four components (402, 404, 406, and 408) collectively driving 150mA in the 30mH coil 410.

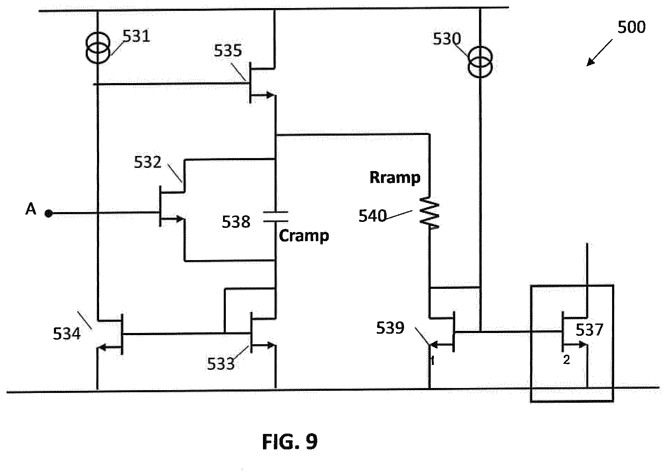

FIG. 9 illustrate an operation that includes generating a linear current ramp from 0-140µA in 6ns, for example, how a linear current 521 can be added to an integrator input element 504, e.g., including an NMOS transistor or the like. Reference can also be made to the circuit shown in FIG. 7. A first closed loop DC current 530 goes in the NMOS mirror current transistors 533, 534 with a gain of 2. Here, a ramp current may increase from 0-80µA in 6ns. As shown in FIG. 9, to accommodate this short timing, the active components may be biased, i.e., not in an off state with 0A current. This is illustrated in FIG. 9. The capacitor 538 can be shorted by the integrator input element 532, e.g., including a NMOS transistor or the like so there is no current in the capacitor 538. For example, when NMOS transistor 532 is open (driven by signal A), the bias current given by the closed loop can flow in the capacitor 538 and generates the linear B signal from 0 to 550mV. However, the NMOS mirror transistors 537, 539 may be biased with the same current as the current 530, through a closed loop formed by current source 531 and NMOS transistors 533, 534, and 535.

Although NMOS transistors are described by way of example, other electromagnetic signal switching electronic devices may equally apply. Therefore, in a DC state, when NMOS transistor 532 coupled to be parallel capacitor 538 is closed, the RC node formed between capacitor 538 and resistor 540 has the same voltage as the voltage (Vgs) of mirror transistor 539 and NMOS mirror current transistor 533, where the resistor 540 has no current. When the signal (A) at the gate of the NMOS transistor 532 is low, the capacitor 538 can be driven by the closed loop formed by current source 531 and NMOS transistors 533, 534, and 535 to receive a constant current equal to currents 530, 531. As the NMOS transistor 535 drives the voltage node (RC), it forces a linear voltage across the capacitor 538 to generate a constant current equal to I(531)=C dV/dt, where C is the capacitance of capacitor 538. The resistor 540 in parallel with the capacitor 538 can receive the same linear voltage transformed in a current ramp by the equation I=U/R. The linear voltage ramp of the capacitor 538 can be applied to the resistance of the resistor 540. As shown in FIG. 7, the NMOS transistor 537 of FIG. 9 can create the current source 421.

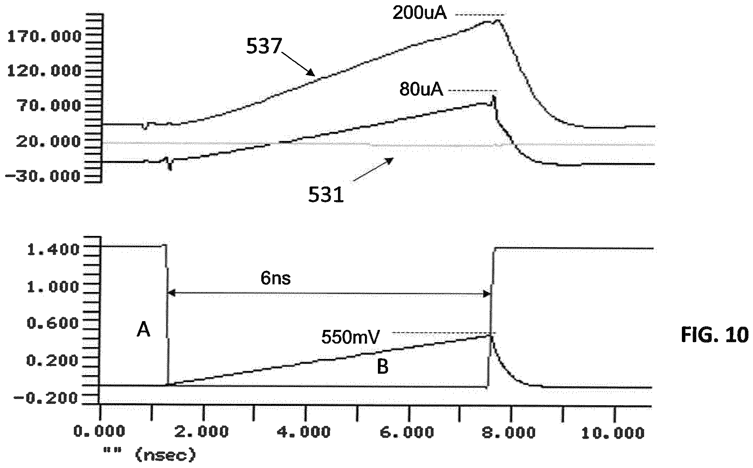

As shown in FIG. 10, the main currents and voltage of the circuit 500 of FIG. 9 provide a linear current ramp from 0-80µA in 6ns (see line IRramp). A digital command (A) can drive the linear voltage ramp (VCramp) from 0-550mV in 6ns, or a range of 4ns-8ns but not limited thereto.

As will be appreciated, embodiments as disclosed include at least the following embodiments. In one embodiment, an electronic integration circuit can comprise a first stage driver; an integrator input element coupled between a voltage source, an input current source, and the first stage driver, the integrator input element that provides a final power stage of the electronic integration circuit and provides a constant drain current in a direct current state that controls a current of the first stage driver; an inductive load driver constructed and arranged to drive an inductive element as a voltage follower stage, wherein the inductive load driver processes a linear gate current to control a current output to the inductive element; and a capacitor between the first stage driver and the integrator input element, wherein a sum of a gate-source voltage of the first stage driver and a gate-source voltage of the integrator input element is provided as an integrator input to the capacitor, and wherein the capacitor performs a linear current ramp integration operation to provide a t² voltage shape across the inductive element required for driving the inductive element in accordance with the controlled current output in a t³ shape.

The integrator input element can provide an additional linear current to maintain a constant integrator input voltage at the integrator input.

The first stage driver, the integrator input element, the inductive load driver, and the capacitor can collectively produce a 6ns pulse that drives 150mA in the inductive element, and wherein the inductive element can include a 30mH coil.

The integrator input element can include an NMOS transistor having a source coupled between a current source and a gate of the first stage driver, a drain coupled to the voltage source, and a gate coupled to the input current source.

At least one of the input current source or a voltage source coupled to the gate of the integrator input element can be constructed and arranged to generate a linear current ramp from 0 to 700µA in 6ns.

The electronic integration circuit can further comprise a voltage switch that places the electronic integration circuit in a direct current state when the integrator input element is connected to a voltage supply by the voltage switch.

The electronic integration circuit can further comprise a first switching device coupled to a copy NMOS transistor connected to the first stage driver; and a second switching device coupled between the gate of the integrator input element, a voltage source, and a current source, wherein the first and second switching devices are constructed and arranged to maintain a DC state current at the integrator input element for generating an integration of a linear input current in the capacitor.

The inductive load drive can have a source coupled to both the capacitor and the inductive element.

The linear current ramp operation can output a linear input current to the capacitor to be integrated and to generate the t² voltage shape and injects little or no current at the integrator input element.

The first stage driver and the integrator input element can provide an integration function so that no input current is in an integrator input signal.

In another embodiment, an electronic integration circuit can comprise an integrator input element coupled to a voltage source and an input current source; a switching device that receives a pulse command that open the switching device to control a current at a gate of the integrator input element and preserve a direct current state of a voltage for a duration of the pulse command; an inductive load driver constructed and arranged to drive an inductive element, wherein the inductive load driver processes a linear gate current to control a current output to the inductive element; and a capacitor at the integrator input element that maintains the DC state at the integrator input element and performs a linear current ramp integration operation according to the pulse command.

The electronic integration circuit can further comprise a copy NMOS transistor; and another switching device coupled between the copy NMOS transistor and the source of the integrator input element, wherein the other power switch is inactivated by a signal to preserve the DC state of the copy NMOS transistor for the pulse duration.

The capacitor can be connected between the gate of the copy NMOS transistor and a drain of the other switching device to permit the DC state current to be maintained at the integrator input element.

The switching device can be turned off when a signal applied to the switching device transitions from a first voltage to a second voltage lower than the first voltage, wherein an input switch command is initiated with an integration current, and as the integration current is received by the capacitor, the electronic integration circuit generates an output having a t² shape driven by the signal.

The t² shape can drive the inductive element in accordance with a controlled current output in a t³ shape.

The integrator input element can be constructed and arranged to generate a linear current ramp from 0 to 700µA. When the linear current ramp is formed whereby a current of up to 700µA flows in the capacitor, an output is generated that drives a current at the inductive element in 6ns or less.

In another embodiment, a driver for a communication bus can comprise an electronic integration circuit, comprising: a first stage driver; an integrator input element coupled between a voltage source, an input current source, and the first stage driver, the integrator input element that provides a final power stage of the electronic integration circuit and provides a constant drain current in a direct current state that controls a current of the first stage driver; an inductive load driver constructed and arranged to drive an inductive element as a voltage follower stage, wherein the inductive load driver processes a linear gate current to control a current output to the inductive element; and a capacitor between the first stage driver and the integrator input element that performs a linear current ramp integration operation for the inductive element.

The integrator input element can provide an additional linear current to maintain a constant integrator input voltage at the integrator input. When the capacitor forms linear current ramp up to 700µA, an output can be generated that drives a current at the inductive element in 6ns or less.

Unless stated otherwise, terms such as "first" and "second" are used to arbitrarily distinguish between the elements such terms describe. Thus, these terms are not necessarily intended to indicate temporal or other prioritization of such elements.

## Claims

1. An electronic integration circuit (100), comprising:
a MOSFET first stage driver (102) configured to drive a voltage follower stage;
a MOSEFT integrator input element (104) having a drain coupled to a voltage source, a gate coupled to an input current source (120) configured to provide a linear current ramp, and a source coupled to both the MOSFET first stage driver (102) and a current source, the MOSFET integrator input element (104) configured to provide a constant drain current in a direct current state that controls a current of the MOSFET first stage driver (102);
an inductive element (110);
a MOSFET inductive load driver (106) constructed and arranged to provide a final power stage of the electronic integration circuit to drive the inductive element (110) as the voltage follower stage, wherein the MOSFET inductive load driver (106) is configured to process a linear gate current to control a current output to the inductive element (110); and
a capacitor (108) between the MOSFET first stage driver (102) and the MOSFET integrator input element (104), wherein a sum of a gate-source voltage of the MOSFET first stage driver (102) and a gate-source voltage of the MOSFET integrator input element (104) is provided as an integrator input to the capacitor (108), and wherein the capacitor (108) performs a linear current ramp integration operation to provide a first quadratic voltage shape across the inductive element (110) required for driving the inductive element (110) in accordance with the controlled current output in a second quadratic voltage shape.

2. The electronic integration circuit of claim 1, wherein the MOSFET integrator input element (104) provides an additional linear current to maintain a constant integrator input voltage at the integrator input.

3. The electronic integration circuit of claim 2, wherein the MOSFET first stage driver (102), the MOSFET integrator input element (104), the MOSFET inductive load driver (106), and the capacitor (108) collectively produce a 6ns pulse that drives 150mA in the inductive element (110), and wherein the inductive element (110) includes a 30mH coil.

4. The electronic integration circuit of any preceding claim, wherein the input current source is constructed and arranged to generate the linear current ramp, from 0 to at least 700µA in at most 6ns.

5. The electronic integration circuit of any preceding claim, further comprising a voltage switch (302) that places the electronic integration circuit in a direct current state when the MOSFET integrator input element (104) is connected to a voltage supply by the voltage switch (302).

6. The electronic integration circuit of any preceding claim, further comprising:
a first switching device (301) coupled to a NMOS transistor (203), 10 times smaller than the MOSFET first stage driver (202) and connected to the MOSFET first stage driver (202); and
a second switching device (302) coupled between the gate of the MOSFET integrator input element (204), the voltage source, and a current source, wherein the first and second switching devices (301, 302) are constructed and arranged to maintain a DC state current at the MOSFET integrator input element (204) for generating an integration of a linear input current in the capacitor (108).

7. The electronic integration circuit of any preceding claim, wherein the MOSFET inductive load driver (106; 206) has a source coupled to both the capacitor (108) and the inductive element (110).

8. The electronic integration circuit of any preceding claim, wherein the linear current ramp operation outputs a linear input current to the capacitor (108) to be integrated and to generate the first quadratic voltage shape and injects no current at the MOSFET integrator input element (104; 204).

9. A driver for a communication bus, comprising:
an electronic integration circuit (100; 200; 300) as claimed in any preceding claim.

## Patentansprüche

1. Elektronische Integrationsschaltung (100), umfassend:
einen MOSFET-Erststufentreiber (102), der ausgelegt ist zum Antreiben einer Spannungsfolgerstufe;
ein MOSFET-Integratoreingangselement (104) mit einem Drain, der mit einer Spannungsquelle gekoppelt ist, einem Gate, das mit einer Eingangsstromquelle (120) gekoppelt ist, die zum Bereitstellen einer linearen Stromrampe ausgelegt ist, und einer Source, die mit sowohl dem MOSFET-Erststufentreiber (102) und einer Stromquelle gekoppelt ist, wobei das MOSFET-Integratoreingangselement (104) ausgelegt ist zum Bereitstellen eines konstanten Drain-Stroms in einem Gleichstromzustand, der einen Strom des MOSFET-Erststufentreibers (102) steuert;
ein induktives Element (110);
einen MOSFET-Treiber (106) für induktive Lasten, der konstruiert und angeordnet ist zum Bereitstellen einer finalen Leistungsstufe der elektronischen Integrationsschaltung, um das induktive Element (110) als die Spannungsfolgerstufe anzutreiben, wobei der MOSFET-Treiber (106) für induktive Lasten ausgelegt ist zum Verarbeiten eines linearen Gate-Stroms, um einen Stromausgang zum induktiven Element (110) zu steuern; und
einen Kondensator (108) zwischen dem MOSFET-Erststufentreiber (102) und dem MOSFET-Integratoreingangselement (104), wobei eine Summe einer Gate-Source-Spannung des MOSFET-Erststufentreibers (102) und einer Gate-Source-Spannung des MOSFET-Integratoreingangselements (104) als ein Integratoreingang in den Kondensator (108) bereitgestellt wird, und wobei der Kondensator (108) eine lineare Stromrampen-Integrationsoperation durchführt, um eine erste quadratische Spannungsform über das induktive Element (110) bereitzustellen, die zum Antreiben des induktiven Elements (110) erforderlich ist, gemäß dem gesteuerten Stromausgang in einer zweiten quadratischen Spannungsform.

2. Elektronische Integrationsschaltung nach Anspruch 1, wobei das MOSFET-Integratoreingangselement (104) einen zusätzlichen linearen Strom bereitstellt, um eine konstante Integratoreingangsspannung am Integratoreingang aufrecht zu erhalten.

3. Elektronische Integrationsschaltung nach Anspruch 2, wobei der MOSFET-Erststufentreiber (102), das MOSFET-Integratoreingangselement (104), der MOSFET-Treiber (106) für induktive Lasten und der Kondensator (108) kollektiv einen 6-ns-Impuls erzeugen, der 150 mA im induktiven Element (110) antreibt, und wobei das induktive Element (110) eine 30-mH-Spule beinhaltet.

4. Elektronische Integrationsschaltung nach einem vorstehenden Anspruch, wobei die Eingangsstromquelle konstruiert und angeordnet ist zum Erzeugen der linearen Stromrampe in höchstens 6 ns von 0 auf mindestens 700 µA**.**

5. Elektronische Integrationsschaltung nach einem vorstehenden Anspruch, ferner umfassend einen Spannungsschalter (302), der die elektronische Integrationsschaltung in einen Gleichstromzustand versetzt, wenn das MOSFET-Integratoreingangselement (104) durch den Spannungsschalter (302) mit einer Spannungsversorgung verbunden wird.

6. Elektronische Integrationsschaltung nach einem vorstehenden Anspruch, ferner umfassend:
eine erste Schaltvorrichtung (301), die mit einem NMOS-Transistor (203) gekoppelt ist, 10 mal kleiner als der MOSFET-Erststufentreiber (202) und verbunden mit dem MOSFET-Erststufentreiber (202); und
eine zweite Schaltvorrichtung (302), die zwischen dem Gate des MOSFET-Integratoreingangselements (204), der Spannungsquelle und einer Stromquelle gekoppelt ist, wobei die erste und zweite Schaltvorrichtung (301, 302) konstruiert und angeordnet sind zum Aufrechterhalten eines DC-Zustandsstroms am MOSFET-Integratoreingangselement (204) zum Erzeugen einer Integration eines linearen Eingangsstroms im Kondensator (108).

7. Elektronische Integrationsschaltung nach einem vorstehenden Anspruch, wobei der MOSFET-Treiber (106; 206) für induktive Lasten eine Source aufweist, die mit sowohl dem Kondensator (108) als auch dem induktiven Element (110) gekoppelt ist.

8. Elektronische Integrationsschaltung nach einem vorstehenden Anspruch, wobei die lineare Stromrampenoperation einen linearen Eingangsstrom an den Kondensator (108) zur Integration und zum Erzeugen der ersten quadratischen Spannungsform ausgibt und keinen Strom am MOSFET-Integratoreingangselement (104; 204) injiziert.

9. Treiber für einen Kommunikationsbus, umfassend:
eine elektronische Integrationsschaltung (100; 200; 300) nach einem vorstehenden Anspruch.

## Revendications

1. Circuit d'intégration électronique (100) comprenant :
un circuit d'attaque de premier étage MOSFET (102) configuré pour attaquer un étage suiveur de tension ;
un élément d'entrée d'intégrateur MOSFET (104) possédant un drain couplé à une source de tension, une grille couplée à une source de courant d'entrée (120) configurée pour fournir une rampe de courant linéaire, et une source couplée à la fois au circuit d'attaque de premier étage MOSFET (102) et à une source de courant, l'élément d'entrée d'intégrateur MOSFET (104) étant configuré pour fournir un courant de drain constant dans un état de courant continu qui commande un courant du circuit d'attaque de premier étage MOSFET (102) ;
un élément inductif (110) ;
un circuit d'attaque de charge inductive MOSFET (106) conçu et agencé pour fournir un étage de puissance final du circuit d'intégration électronique pour attaquer l'élément inductif (110) en tant qu'étage suiveur de tension, le circuit d'attaque de charge inductive MOSFET (106) étant configuré pour traiter un courant de grille linéaire pour commander une sortie de courant vers l'élément inductif (110) ; et
un condensateur (108) entre le circuit d'attaque de premier étage MOSFET (102) et l'élément d'entrée d'intégrateur MOSFET (104), une somme d'une tension grille-source du circuit d'attaque de premier étage MOSFET (102) et d'une tension grille-source de l'élément d'entrée d'intégrateur MOSFET (104) étant fournie en tant qu'entrée d'intégrateur au condensateur (108), et le condensateur (108) effectuant une opération d'intégration de rampe de courant linéaire pour fournir une première forme de tension quadratique aux bornes de l'élément inductif (110) nécessaire pour attaquer l'élément inductif (110) en fonction de la sortie de courant commandée dans une deuxième forme de tension quadratique.

2. Circuit d'intégration électronique selon la revendication 1, dans lequel l'élément d'entrée d'intégrateur MOSFET (104) fournit un courant linéaire supplémentaire pour maintenir une tension d'entrée d'intégrateur constante à l'entrée d'intégrateur.

3. Circuit d'intégration électronique selon la revendication 2, dans lequel le circuit d'attaque de premier étage MOSFET (102), l'élément d'entrée d'intégrateur MOSFET (104), le circuit d'attaque de charge inductive MOSFET (106) et le condensateur (108) produisent collectivement une impulsion de 6 ns qui transmet 150 mA dans l'élément inductif (110), et l'élément inductif (110) comportant une bobine de 30 mH.

4. Circuit d'intégration électronique selon l'une quelconque des revendications précédentes, dans lequel la source de courant d'entrée est conçue et agencée pour générer la rampe de courant linéaire, de 0 à au moins 700 µA dans au plus 6 ns.

5. Circuit d'intégration électronique selon l'une quelconque des revendications précédentes, comprenant en outre un commutateur de tension (302) qui place le circuit d'intégration électronique dans un état de courant continu lorsque l'élément d'entrée d'intégrateur MOSFET (104) est connecté à une alimentation en tension par le commutateur de tension (302).

6. Circuit d'intégration électronique selon l'une quelconque des revendications précédentes, comprenant en outre :
un premier dispositif de commutation (301) couplé à un transistor NMOS (203), 10 fois plus petit que le circuit d'attaque de premier étage MOSFET (202) et connecté au circuit d'attaque de premier étage MOSFET (202) ; et
un deuxième dispositif de commutation (302) couplé entre la grille de l'élément d'entrée d'intégrateur MOSFET (204), la source de tension et une source de courant, les premier et deuxième dispositifs de commutation (301, 302) étant conçus et agencés pour maintenir un courant d'état CC au niveau de l'élément d'entrée d'intégrateur MOSFET (204) afin de générer une intégration d'un courant d'entrée linéaire dans le condensateur (108).

7. Circuit d'intégration électronique selon l'une quelconque des revendications précédentes, dans lequel le circuit d'attaque de charge inductive MOSFET (106 ; 206) a une source couplée à la fois au condensateur (108) et à l'élément inductif (110).

8. Circuit d'intégration électronique selon l'une quelconque des revendications précédentes, dans lequel le fonctionnement en rampe de courant linéaire délivre un courant d'entrée linéaire au condensateur (108) à intégrer et pour générer la première forme de tension quadratique et n'injecte aucun courant au niveau de l'élément d'entrée d'intégrateur MOSFET (104 ; 204).

9. Circuit d'attaque pour un bus de communication, comprenant :
un circuit d'intégration électronique (100 ; 200 ; 300) selon l'une quelconque des revendications précédentes.
